# EUROPÄISCHE PATENTSCHRIFT

(11) **EP 4 051 918 B1**
(45) Veröffentlichungstag und Bekanntmachung des Hinweises auf die Patenterteilung: **12.03.2025**
(21) Anmeldenummer: 20800103.2
(22) Anmeldetag: 29.10.2020
(51) Int. Cl.: F16D 1/00, F16C 35/04, F16C 35/077, G01M 13/022, G01R 31/34, G01M 7/02, G01M 13/025, G01M 13/028

(54) **PRÜFSTAND**
TEST BENCH
BANC D'ESSAI

(30) Priorität: 30.10.2019 DE 102019216750
(43) Veröffentlichungstag der Anmeldung: 07.09.2022
(73) Patentinhaber: ZF Friedrichshafen AG, 88046 Friedrichshafen (DE)
(72) Erfinder: JUSE, Matthias, 4784 Schardenberg (AT); HELL, Christian, 94107 Untergriesbach (DE)
(86) Internationale Anmeldenummer: PCT/EP2020/080415
(87) Internationale Veröffentlichungsnummer: WO 2021/084017

(56) Entgegenhaltungen:
- DE-A1- 102010 046 597
- DE-A1- 102016 224 142
- DE-C- 509 315
- DE-C- 871 856
- US-A- 2 670 253

## Beschreibung

Die Erfindung bezieht sich auf einen Prüfstand mit einem Grundgestell, auf dem ein Prüfstandsantrieb mit einer um eine Drehachse drehbar antreibbaren Prüfwelle angeordnet ist, wobei die Prüfwelle koaxial mit einer um die Drehachse drehbar gelagerten Lagerwelle einer Lagereinheit verbindbar ist, wobei die Lagereinheit in einer zur Drehachse koaxialen Ausnehmung eines mit dem Grundgestell fest verbundenen Lagergehäuses lösbar angeordnet ist, und die Lagerwelle an ihrem dem Prüfstandsantrieb abgewandten, aus dem Lagergehäuse herausragenden Ende ein Befestigungselement zur lösbaren Befestigung eines Prüflings aufweist.

Derartige Prüfstände werden u.a. dazu benutzt an dem drehend angetriebenen Prüfling Akustik-, Schwingungs-, Drehmoment- und Funktionsprüfungen durchzuführen. Prüflinge können z. B. Elektromotoren und Getriebe insbesondere für Elektroantriebe von Fahrzeugen sein.

Bei diesen Prüfungen entstehen hohe Belastungen der Lagereinheit, so daß diese schnell verschleißt und ausgetauscht werden muß. Da die Drehachse des Prüfstandsantriebs und der Lagerwelle mit hoher Genauigkeit koaxial sein muß und keine Verfälschung der Meßergebnisse zu erhalten, ist bei einem Austausch der Lagereinheit ein zeit- und montageaufwendiges Neuausrichten des Prüfstandsantriebs zur Lagerwelle erforderlich.

Aus der DE 10 2016 224 142 A1 ist ein Prüfstand der eingangs genannten Art bekannt.

Aus der DE 509 315 C ist ein nachstellbares Rollenlager bekannt, bei dem auf einer Arbeitsspindel ein Innenlaufring angeordnet ist, auf dem die Rollen des Lagers angeordnet sind. Der Außenlaufring des Lagers besteht aus einem axial gewickelten Federlaufband, dessen Außenkontur konisch geschliffen und in einer Hülse gleichem Gegenkonus gelagert ist. Die Hülse mit ihrer Außenkontur ist in eine Bohrung eines Lagerkörpers eingesetzt. Das Federband ist durch Verdrehen enger wickelbar. Außerdem ist die Hülse gegenüber dem Federband verschiebbar.

Aus der US 2 670 235 A und der DE 871 856 C ist ein Nadellager bekannt, das auf eine Welle angeordnet ist. Der Außenring des Nadellagers ist als längsgeschlitzte Hülse und an seiner Außenseite konisch ausgebildet und an einer entsprechend konischen Innenseite eines hülsenartigen Außenrings abgestützt. Axial ist der Außenring des Nadellagers mittels einer Spannmutter nachspannbar.

Aufgabe der Erfindung ist es einen Prüfstand der eingangs genannten Art zu schaffen, dessen Lagereinheit bei einfachem Aufbau schnell und positionsgenau montierbar ist.

Diese Aufgabe wird erfindungsgemäß dadurch gelöst, daß die koaxiale Ausnehmung im Lagergehäuse eine zur Drehachse symmetrische kegelabschnittförmige Ausnehmung ist, in die eine Lagerhülse der Lagereinheit drehfest lösbar angeordnet ist, die eine äußere Kegelwandung aufweist, welche mit ihrer zumindest teilweise gleichen Außenkontur wie der Kontur der Wandung der kegelabschnittförmigen Ausnehmung an der Wandung der kegelabschnittförmigen Ausnehmung in Anlage ist, wobei die Lagerhülse eine zur Drehachse koaxiale durchgehende Lagerbohrung aufweist in der über ein oder mehrere Lager die Lagerwelle drehbar gelagert ist.

Der Prüfstandsantrieb ist vorzugsweise ein Elektromotor.

Durch die erfindungsgemäße Ausbildung bildet die Lagereinheit aus Lagerhülse, Lager und Lagerwelle eine leicht vormontierbare Baueinheit.

Diese Baueinheit wird beim Einbau mit ihrer äußeren Kegelwandung in der kegelabschnittförmige Ausnehmung spielfrei und mit sehr hoher Positionsgenauigkeit exakt koaxial zur Drehachse des Prüfstandsantriebs ausgerichtet eingesetzt, so daß kein weiteres Ausrichten erforderlich ist. Dies ermöglicht eine schnelle Austauschbarkeit der Lagereinheit.

Die Lastabtragung von der Lagerwelle erfolgt im Bereich der Lager über die Lagerhülse direkt in das Lagergehäuse und das Grundgestell.

Ist das Ende geringeren Durchmessers der kegelabschnittsförmigen Ausnehmung dem Prüfstandsantrieb zugewandt, so besteht ein weitgehend ungehinderter Zugang zur kegelabschnittförmigen Ausnehmung.

Der Kegelwinkel der kegelabschnittförmigen Ausnehmung kann zwischen 1° und 5° betragen. Vorzugsweise beträgt der Kegelwinkel zwischen 1° und 3°, insbesondere 2°. Dadurch erfolgt nicht nur eine exakte koaxiale Ausrichtung der Lagereinheit sondern auch eine gute Krafteinleitung der Lagerkräfte in das Lagergehäuse.

Um ein sicheres Anliegen der äußeren Kegelwandung der Lagerhülse an der kegelabschnittsförmigen Ausnehmung zu gewährleisten, kann die äußere Kegelwandung der Lagerhülse durch Kegelwandungsabschnitte in den beiden Endbereichen der Lagerhülse ausgebildet sein, zwischen denen die Lagerhülse mit einer radial umlaufenden Ringvertiefung ausgebildet ist.

Die Lagerwelle kann über in den beiden Endbereichen der Lagerbohrung angeordnete Wälzlager und/oder Gleitlager in der Lagerbohrung drehbar gelagert sein.

Um die Schwingungen während des Prüfbetriebs gut aufzunehmen und damit Verfälschungen der Prüfdaten zumindest weitgehend zu vermeiden, können die Lagerhülse und/oder das Grundgestell und/oder das Lagergehäuse als schwingungsdämpfende Komponentemit einer hohe Eigendämpfung ausgebildet sein.

Vorzugsweise ist dabei das Lagergehäuse mit dem Grundgestell einteilig ausgebildet.

Auch kann das Lagergehäuse ein kompaktes, eine große Masse aufweisendes Bauteil mit insbesondere einer großen Wanddicke sein.

Um die Lagereinheit schnell demontieren bzw. montieren zu können, kann die Lagerhülse an ihrem Ende größeren Durchmessers eine radial umlaufende Ringschulter aufweisen, an deren dem Ende geringeren Durchmessers der Lagerhülse abgewandten Seite ein Sicherungselement axial in Anlage ist, das lösbar an dem Lagergehäuse befestigbar ist.

Dazu kann in einfacher Weise das Sicherungselement ein Klemmring sein, der in eine koaxiale Ringnut des Lagergehäuses einsetzbar ist.

Das Befestigungselement des aus dem Lagergehäuse herausragenden Endes der Lagerwelle kann ein Befestigungsflansch sein.

Ein Ausführungsbeispiel der Erfindung ist in der Zeichnung dargestellt und wird im Folgenden näher beschrieben. Es zeigen:
- Figur 1: eine perspektivische Darstellung einer Prüfstandsanordnung
- Figur 2: eine Seitenansicht der Prüfstandsanordnung nach Figur 1

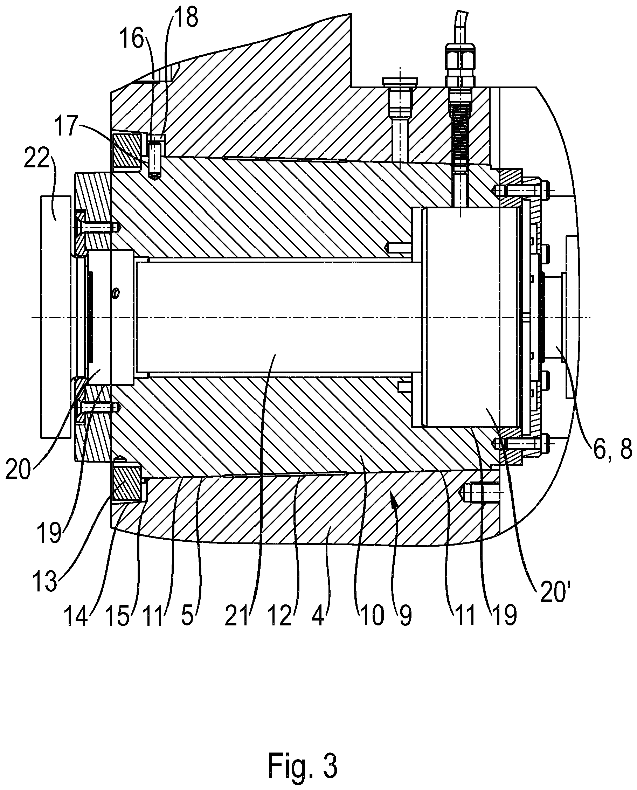

- Figur 3: einen vergrößerten Ausschnitt "X" des Prüfstand der Prüfstandsanordnung nach Figur 2.

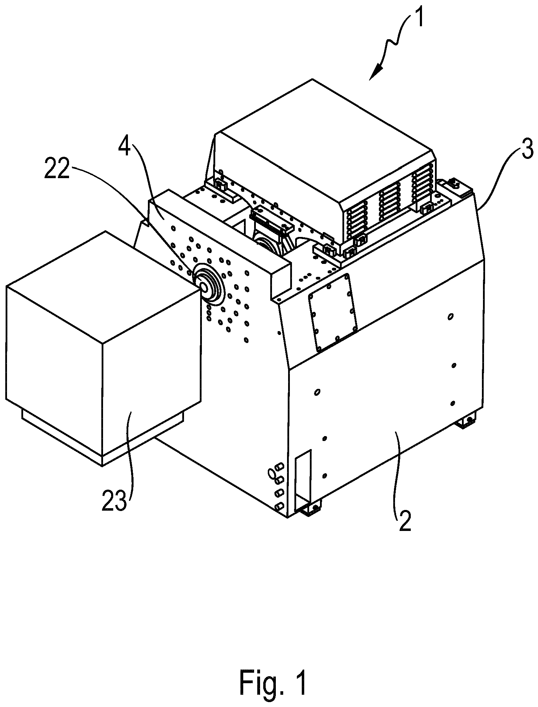

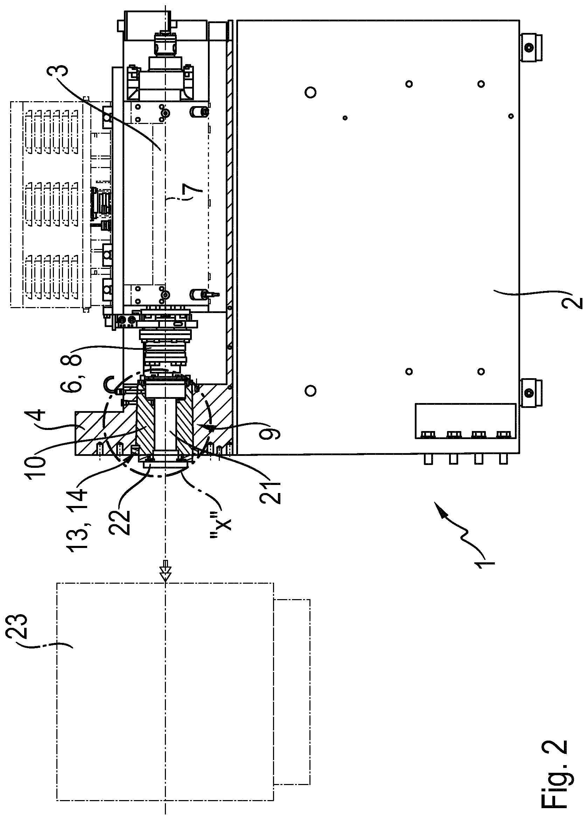

Die Prüfstandsanordnung nach den Figuren 1 und 2 zeigt einen Prüfstand 1, der ein Grundgestell 2 aufweist, auf dem als Prüfstandsantrieb ein Elektromotor 3 und ein Lagergehäuse 4 fest angeordnet sind.

Grundgestell 2 und Lagergehäuse 4 sind einteilig ausgebildet und weisen schwingungsdämpfende Eigenschaften auf. Dies kann dadurch sein, daß Grundgestell 2 und Lagergehäuse 4 aus einem mit einem Beton gefüllten Gehäuse bestehen.

Der Elektromotor 3 weist eine von ihm um eine Drehachse 7 drehbar antreibbare Prüfwelle 6 auf, die als ein koaxial zur Drehachse 7 zum Lagergehäuse 4 führender Antriebsstrang 8 ausgebildet ist, an dem eine nicht dargestellte Drehmomentmeßeinrichtung sowie weitere Meßeinrichtungen angeordnet sein können.

Das Lagergehäuse 4 weist eine zur Drehachse koaxiale und symmetrische kegelabschnittsförmige Ausnehmung 5 mit einem Kegelwinkel von 2° auf, deren Ende geringeren Durchmessers dem Elektromotor 3 zugewandt ist.

In die kegelabschnittsförmige Ausnehmung 5 ist eine Lagerhülse 10 einer Lagereinheit 9 eingesetzt, wobei die Lagerhülse 10 eine der kegelabschnittsförmige Ausnehmung 5 entsprechende äußere Kegelwandung besitzt. Die äußere Kegelwandung der Lagerhülse 10 ist durch Kegelwandungsbereiche 11 in den beiden Endbereichen der Lagerhülse 10 gebildet. Zwischen den beiden Kegelwandungsbereichen 11 ist eine Ringvertiefung 12 ausgebildet, so daß die Lagerhülse 10 nur mit ihren Kegelwandungsbereichen 11 an der Wandung der kegelabschnittsförmigen Ausnehmung 5 in Anlage ist.

Gemäß einem weiteren, nicht in den Figuren dargestellten Ausführungsbeispiel, ist keine Ringvertiefung 12 vorgesehen.

Die Lagerhülse 10 ist von der linken Seite her bis zur Anlage der Kegelwandungsbereichen 11 über 360° in Umfangsrichtung an der Wandung der kegelabschnittsförmigen Ausnehmung 5 in die Ausnehmung 5 eingeschoben und durch einen Klemmring 13 in der Einbaulage gesichert. Der Klemmring 13 ist dabei in eine Ringnut 14 des Lagergehäuses 4 eingesetzt.

Dabei wird ein Spalt gelassen, so dass der Ring 13 die Lagerhülse 10 passgenau in den Kegelsitz 11 drücken kann. Die axiale Lage der Lagerhülse 10 wird durch den im Durchmesser präzise gefertigten Kegel beider Bauteile sichergestellt.

Gegen Verdrehen ist die Lagerhülse 10 durch einen Stift 16 gesichert, der in eine entsprechende Radialbohrung 17 in der Lagerhülse 10 fest eingesetzt ist und aus dieser radial heraus in einen Schlitz 18 gleicher Breite wie der Stift 16 hineinragt. Der in dem Lagergehäuse 4 ausgebildete Schlitz 18 ist zur dem Elektromotor 3 abgewandten Stirnseite des Lagergehäuses 4 hin offen.

Die Lagerhülse 10 besitzt eine koaxial zur Drehachse 7 durchgehende Lagerbohrung 19, in deren axialen Endbereichen Wälzlager 20, 20' mit ihren Außenringen eingesetzt sind. Die Innenringe der Wälzlager 20, 20' sind auf einer Lagerwelle 21 angeordnet. Anstelle von Wälzlagern 20, 20' könnten auch Gleitlager 20, 20' verwendet werden.

Die Lagerwelle 21 ist an ihrem rechten Ende mit dem Antriebsstrang 8 lösbar verbunden, während das aus der Lagerhülse 10 herausragende linke Ende der Lagerwelle 21 mit einem Befestigungsflansch 22 versehen ist.

In einem Aufnahmegehäuse 23 ist ein nicht dargestellter zu prüfender drehbar antreibbarer Prüfling anordenbar. Der Prüfling kann z.B. ein Elektroantrieb insbesondere für ein Fahrzeug oder ein Getriebemodul sein. Dabei wird eine Welle des Prüflings koaxial zur Drehachse 7 drehfest mit dem Befestigungsflansch 22 und das Aufnahmegehäuse 23 mit dem Lagergehäuse 4 (oder alternativ mit einem nicht dargestellten Unterbau unterhalb des Prüflings),drehfest verbunden. Die Verbindung der Welle des Prüflings kann unmittelbar oder über eine Kupplung oder Gelenkwelle indirekt verbunden werden.

### Bezugszeichen

- 1: Prüfstand
- 2: Grundgestell
- 3: Elektromotor
- 4: Lagergehäuse
- 5: Ausnehmung
- 6: Prüfwelle
- 7: Drehachse
- 8: Antriebsstrang
- 9: Lagereinheit
- 10: Lagerhülse
- 11: Kegelwandungsbereiche
- 12: Ringvertiefung
- 13: Klemmring
- 14: Ringnut
- 15: Ringschulter
- 16: Stift
- 17: Radialbohrung
- 18: Schlitz
- 19: Lagerbohrung
- 20: Wälzlager oder Gleitlager
- 20': Wälzlager oder Gleitlager
- 21: Lagerwelle
- 22: Befestigungsflansch
- 23: Aufnahmegehäuse

## Patentansprüche

1. Prüfstand (1) mit einem Grundgestell (2), auf dem ein Prüfstandsantrieb mit einer um eine Drehachse (7) drehbar antreibbaren Prüfwelle (6) angeordnet ist, wobei die Prüfwelle (6) koaxial mit einer um die Drehachse (7) drehbar gelagerten Lagerwelle (21) einer Lagereinheit (9) verbindbar ist, wobei die Lagereinheit (9) in einer zur Drehachse (7) koaxialen Ausnehmung (5) eines mit dem Grundgestell (2) fest verbundenen Lagergehäuses (4) lösbar angeordnet ist, und die Lagerwelle (21) an ihrem dem Prüfstandsantrieb abgewandten, aus dem Lagergehäuse (4) herausragenden Ende ein Befestigungselement zur lösbaren Befestigung eines Prüflings aufweist, **dadurch gekennzeichnet, daß** die koaxiale Ausnehmung (5) im Lagergehäuse (4) eine zur Drehachse (7) symmetrische kegelabschnittförmige Ausnehmung (5) ist, in die eine Lagerhülse (10) der Lagereinheit (9) drehfest lösbar angeordnet ist, die eine äußere Kegelwandung aufweist, welche mit ihrer zumindest teilweise gleichen Außenkontur wie der Kontur der Wandung der kegelabschnittförmigen Ausnehmung (5) an der Wandung der kegelabschnittförmigen Ausnehmung (5) in Anlage ist, wobei die Lagerhülse (10) eine zur Drehachse (7) koaxiale durchgehende Lagerbohrung (19) aufweist in der über ein oder mehrere Lager die Lagerwelle (21) drehbar gelagert ist.

2. Prüfstand nach Anspruch 1, **dadurch gekennzeichnet, dass** das Ende geringeren Durchmessers der kegelabschnittsförmigen Ausnehmung (5) dem Prüfstandsantrieb zugewandt ist.

3. Prüfstand nach einem der vorhergehenden Ansprüche, **dadurch gekennzeichnet, dass** der Kegelwinkel der kegelabschnittförmigen Ausnehmung (5) zwischen 1° und 5° beträgt.

4. Prüfstand nach einem der vorhergehenden Ansprüche, **dadurch gekennzeichnet, dass** die äußere Kegelwandung der Lagerhülse (10) durch Kegelwandungsabschnitte (11) in den beiden Endbereichen der Lagerhülse (10) ausgebildet ist, zwischen denen die Lagerhülse (10) mit einer radial umlaufenden Ringvertiefung (12) ausgebildet ist.

5. Prüfstand nach einem der vorhergehenden Ansprüche, **dadurch gekennzeichnet, dass** die Lagerwelle (21) über in den beiden Endbereichen der Lagerbohrung (19) angeordnete Wälzlager (20, 20') und/oder Gleitlager in der Lagerbohrung (19) drehbar gelagert sind.

6. Prüfstand nach einem der vorhergehenden Ansprüche, **dadurch gekennzeichnet, dass** die Lagerhülse (10) und/oder das Grundgestell (2) und/oder das Lagergehäuse (4) als schwingungsdämpfender, eine hohe Eigendämpfung aufweisender Körper ausgebildet ist.

7. Prüfstand nach einem der vorhergehenden Ansprüche, **dadurch gekennzeichnet, dass** die Lagerhülse (10) an ihrem Ende größeren Durchmessers eine radial umlaufende Ringschulter (15) aufweist, an deren dem Ende geringeren Durchmessers der Lagerhülse (10) abgewandten Seite ein Sicherungselement axial in Anlage ist, das lösbar an dem Lagergehäuse (4) befestigbar ist.

8. Prüfstand nach Anspruch 6, **dadurch gekennzeichnet, dass** das Sicherungselement ein Klemmring (13) ist, der in eine koaxiale Ringnut (14) des Lagergehäuses (4) einsetzbar ist.

9. Prüfstand nach einem der vorhergehenden Ansprüche, **dadurch gekennzeichnet, dass** das Befestigungselement des aus dem Lagergehäuse (4) herausragenden Endes der Lagerwelle (21) ein Befestigungsflansch (22) ist.

## Claims

1. Test bench (1) with a base frame (2) on which a test bench drive is arranged, having a test shaft (6) that can be driven rotationally about an axis of rotation (7), wherein the test shaft (6) can be connected coaxially to a bearing shaft (21) of a bearing unit (9) that is mounted rotatably about the axis of rotation (7), wherein the bearing unit (9) is releasably arranged in a recess (5), coaxial with the axis of rotation (7), of a bearing housing (4) that is fixedly connected to the base frame (2), and the bearing shaft (21) has, at its end projecting from the bearing housing (4) and facing away from the test bench drive, a fastening element for the releasable attachment of a test specimen, **characterized in that** the coaxial recess (5) in the bearing housing (4) is a conical-section-shaped recess (5) symmetrical to the axis of rotation (7), in which a bearing sleeve (10) of the bearing unit (9) is non-rotatably and releasably arranged, said bearing sleeve having an outer conical wall which, with its at least partially matching outer contour, conforms to the contour of the wall of the conical-section-shaped recess (5) and is in contact with the wall of the conical-section-shaped recess (5), wherein the bearing sleeve (10) also has a through-bearing bore (19) coaxial with the axis of rotation (7), in which the bearing shaft (21) is rotatably supported via one or multiple bearings.

2. Test bench according to Claim 1, **characterized in that** the smaller-diameter end of the conical-section-shaped recess (5) faces the test bench drive.

3. Test bench according to any one of the preceding claims, **characterized in that** the cone angle of the conical-section-shaped recess (5) is between 1° and 5°.

4. Test bench according to any one of the preceding claims, **characterized in that** the outer conical wall of the bearing sleeve (10) is formed by conical wall sections (11) in the two end regions of the bearing sleeve (10), between which the bearing sleeve (10) is formed with a radially circumferential annular recess (12).

5. Test bench according to any one of the preceding claims, **characterized in that** the bearing shaft (21) is rotatably supported in the bearing bore (19) via rolling bearings (20, 20') and/or plain bearings positioned at both axial end regions of the bearing bore (19).

6. Test bench according to any one of the preceding claims, **characterized in that** the bearing sleeve (10) and/or the base frame (2) and/or the bearing housing (4) is designed as a vibration-damping body with high inherent damping properties.

7. Test bench according to any one of the preceding claims, **characterized in that** the larger-diameter end of the bearing sleeve (10) has a circumferential shoulder (15) at its larger-diameter end, on the side of which, facing away from the smaller-diameter end of the bearing sleeve (10), a securing element is axially positioned in contact and can be releasably fastened to the bearing housing (4).

8. Test bench according to Claim 6, **characterized in that** the securing element is a clamping ring (13) that can be inserted into a coaxial groove (14) of the bearing housing (4).

9. Test bench according to any one of the preceding claims, **characterized in that** the fastening element on the end of the bearing shaft (21) projecting from the bearing housing (4) is a fastening flange (22).

## Revendications

1. Banc d'essai (1) avec un châssis de base (2), sur lequel est agencé un entraînement de banc d'essai avec un arbre d'essai (6) pouvant être entraîné en rotation autour d'un axe de rotation (7), l'arbre d'essai (6) pouvant être relié coaxialement à un arbre de palier (21) d'une unité de palier (9) logé de manière rotative autour de l'axe de rotation (7), l'unité de palier (9) étant agencée de manière amovible dans un évidement (5), coaxial à l'axe de rotation (7), d'un boîtier de palier (4) relié de manière fixe au châssis de base (2), et l'arbre de palier (21) présentant, à son extrémité détournée de l'entraînement de banc d'essai, dépassant du boîtier de palier (4), un élément de fixation pour la fixation amovible d'un objet à tester, **caractérisé en ce que** l'évidement coaxial (5) dans le boîtier de palier (4) est un évidement (5) en forme de section conique symétrique par rapport à l'axe de rotation (7), dans lequel est agencé de manière amovible et solidaire en rotation un manchon de palier (10) de l'unité de palier (9), qui présente une paroi conique extérieure, qui est en appui avec la paroi de l'évidement en forme de section conique (5) avec son contour extérieur au moins partiellement identique au contour de la paroi de l'évidement en forme de section conique (5), le manchon de palier (10) présentant un alésage de palier (19) traversant coaxial à l'axe de rotation (7), dans lequel l'arbre de palier (21) est logé de manière rotative par l'intermédiaire d'un ou de plusieurs paliers.

2. Banc d'essai selon la revendication 1, **caractérisé en ce que** l'extrémité de plus petit diamètre de l'évidement en forme de section conique (5) est tournée vers l'entraînement de banc d'essai.

3. Banc d'essai selon l'une quelconque des revendications précédentes, **caractérisé en ce que** l'angle de conicité de l'évidement en forme de section conique (5) est compris entre 1° et 5°.

4. Banc d'essai selon l'une quelconque des revendications précédentes, **caractérisé en ce que** la paroi conique extérieure du manchon de palier (10) est réalisée par des sections de paroi conique (11) dans les deux zones d'extrémité du manchon de palier (10), entre lesquelles le manchon de palier (10) est réalisé avec un creux annulaire (12) périphérique radial.

5. Banc d'essai selon l'une quelconque des revendications précédentes, **caractérisé en ce que** l'arbre de palier (21) est logé de manière rotative dans l'alésage de palier (19) par l'intermédiaire de paliers à roulement (20, 20') et/ou de paliers lisses agencés dans les deux zones d'extrémité de l'alésage de palier (19) .

6. Banc d'essai selon l'une quelconque des revendications précédentes, **caractérisé en ce que** le manchon de palier (10) et/ou le châssis de base (2) et/ou le logement de palier (4) est réalisé sous forme de corps amortissant les vibrations, présentant un amortissement propre élevé.

7. Banc d'essai selon l'une quelconque des revendications précédentes, **caractérisé en ce que** le manchon de palier (10) présente à son extrémité de plus grand diamètre un épaulement annulaire (15) périphérique radial, sur le côté duquel, détourné de l'extrémité de plus petit diamètre du manchon de palier (10), est en appui axial un élément de blocage qui peut être fixé de manière amovible sur le boîtier de palier (4).

8. Banc d'essai selon la revendication 6, **caractérisé en ce que** l'élément de blocage est une bague de serrage (13) qui peut être insérée dans une rainure annulaire coaxiale (14) du boîtier de palier (4).

9. Banc d'essai selon l'une quelconque des revendications précédentes, **caractérisé en ce que** l'élément de fixation de l'extrémité de l'arbre de palier (21) qui dépasse du boîtier de palier (4) est une bride de fixation (22) .
